(19) **Europäisches Patentamt / European Patent Office / Office européen des brevets**

(11) **EP 4 318 005 B1**

(12) **EUROPEAN PATENT SPECIFICATION**

(45) Date of publication and mention
of the grant of the patent:
**04.06.2025 Bulletin 2025/23**

(21) Application number: **22919066.5**

(22) Date of filing: **21.12.2022**

(51) International Patent Classification (IPC):
*G01R 31/367* (2019.01)   *G01R 31/374* (2019.01)
*G01R 31/3842* (2019.01)   *G01R 31/392* (2019.01)
*G01R 19/165* (2006.01)   *G01R 19/00* (2006.01)
*G01R 19/30* (2006.01)   *G01R 31/387* (2019.01)

(52) Cooperative Patent Classification (CPC):
**G01R 31/367; G01R 31/387; G01R 31/392**

(86) International application number:
**PCT/KR2022/021010**

(87) International publication number:
**WO 2023/132529 (13.07.2023 Gazette 2023/28)**

(54) **BATTERY STATE ESTIMATING APPARATUS AND METHOD**

VORRICHTUNG UND VERFAHREN ZUR SCHÄTZUNG DES BATTERIEZUSTANDS

APPAREIL ET PROCÉDÉ D'ÉVALUATION D'ÉTAT DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **04.01.2022 KR 20220001089**

(43) Date of publication of application:
**07.02.2024 Bulletin 2024/06**

(73) Proprietor: **LG ENERGY SOLUTION, LTD.**
**Seoul 07335 (KR)**

(72) Inventors:
• **KIM, An-Soo**
**Daejeon 34122 (KR)**
• **KWON, Dong-Keun**
**Daejeon 34122 (KR)**
• **KIM, Seung-Hyun**
**Daejeon 34122 (KR)**
• **SHIN, Chae-Bin**
**Daejeon 34122 (KR)**
• **LEE, Hyun-Chul**
**Daejeon 34122 (KR)**

(74) Representative: **Plasseraud IP**
**104 Rue de Richelieu**
**CS92104**
**75080 Paris Cedex 02 (FR)**

(56) References cited:
EP-B1- 3 593 155   WO-A1-2021/118311
CN-A- 110 333 456   KR-A- 20160 002 336
KR-A- 20190 069 894   KR-A- 20210 050 990
KR-B1- 101 486 470   US-A1- 2021 215 768

• ZHENG YONGLIANG, HE FENG, WANG WENLIANG: "SOC Estimation of Lithium Battery Based on Dual Adaptive Extended Kalman Filter", IOP CONFERENCE SERIES: MATERIALS SCIENCE AND ENGINEERING, INSTITUTE OF PHYSICS PUBLISHING LTD., GB, vol. 677, no. 3, 1 December 2019 (2019-12-01), GB , pages 032077, XP093076232, ISSN: 1757-8981, DOI: 10.1088/1757-899X/677/3/032077

EP 4 318 005 B1

**Description**

<u>TECHNICAL FIELD</u>

The present application claims priority to Korean Patent Application No. 10-2022-0001089 filed on January 4, 2022 in the Republic of Korea.

The present invention relates to a battery state estimating apparatus and method, and more particularly, to a battery state estimating apparatus and method capable of more accurately estimating a battery state by adding system noise to a recursive filter used for estimating the battery state.

<u>BACKGROUND ART</u>

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

In general, battery state information such as state of charge (SOC) and state of health (SOH) can be estimated based on measurable voltage, current, and temperature. For example, the battery's SOC and SOH may be estimated using an extended Kalman filter, which is a type of recursive filter. Here, SOC means the current state of charge of the battery. In addition, SOH is the remaining life of the battery, and may mean the current life of the battery due to deterioration, assuming that the initial life of the BOL (Beginning of life) battery is 100%.

In addition, in order to more accurately estimate the battery state information, a study on a dual adaptive extended Kalman filter, which has supplemented the extended Kalman filter, was conducted (Non-patent Literature 1).

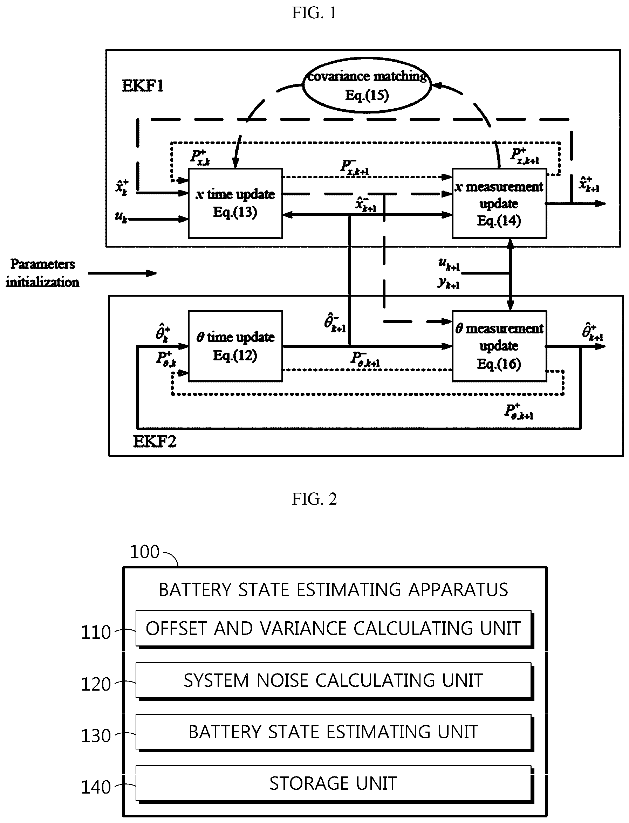

FIG. 1 is a diagram showing a flowchart of a conventional dual adaptive extended Kalman filter. Specifically, FIG. 1 is a flowchart of Non-patent Literature 1, and "Eq." described in FIG. 1 means an equation of Non-patent Literature 1.

Referring to Equation 12 and Equation 13 of Non-Patent Literature 1, Q is used as process noise (system noise). However, Non-patent Literature 1 only uses multivariate normal distribution $W_k \sim N(0, Q)$ noise, and does not consider the offset and variance of the current sensor and voltage sensor that can affect system noise.

That is, in the process of estimating SOC and SOH, Non-patent Literature 1 cannot reflect the offset of a current sensor installed on the charging and discharging path of the battery to measure the discharging current and/or charging current of the battery, and a voltage sensor to measure the voltage of the battery, so there is a problem that the accuracy of the estimated SOC and SOH may be lowered. CN110333456-A discloses a method for estimating a SOC of a battery, which comprises obtaining a current value of the battery when the battery is not charged and not discharging, as a current offset value. During the charging or discharging of the battery, an SOC value of the battery is estimated according to an equivalent circuit model of the battery and an extended Kalman filter method, wherein the process noise parameter and the measurement noise parameter are determined according to the current offset value.

(Non-patent Literature 1) SOC Estimation of Lithium Battery Based on Dual Adaptive Extended Kalman Filter (IMMAEE 2019, Yongliang Zheng et al., 2019)

<u>DISCLOSURE</u>

<u>Technical Problem</u>

The present disclosure is designed to solve the problems of the related art, and therefore the present disclosure is directed to providing a battery state estimating apparatus and method for more accurately estimating a battery state by considering an offset and variance of a current sensor and a voltage sensor.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims.

<u>Technical Solution</u>

A battery state estimating apparatus according to one aspect of the present disclosure may comprise an offset and variance calculation unit configured to calculate a voltage offset and a voltage variance based on a voltage value of a battery obtained during a predetermined period and calculate a current offset and a current variance based on a current value of the battery obtained during the predetermined period; a system noise calculation unit configured to calculate an offset noise matrix and a variance noise matrix based on the voltage offset, the voltage variance, a preset voltage measurement specification, the current offset, the current variance and a preset current measurement specification and calculate a system noise from the offset noise matrix and the variance noise matrix; and a battery state estimation unit configured to estimate state information of the battery by applying the system noise to a preset recursive filter.

The offset noise matrix may be configured as a matrix including a first offset component and a second offset component.

The system noise calculation unit may be configured to calculate the first offset component based on the current offset and the current measurement specification and calculate the second offset component based on the voltage offset and the voltage measurement specification.

The system noise calculation unit may be configured to calculate the first offset component using Equation 1 below,

[Equation 1]

$$w_1 = w_{1\_min} + \left( \frac{offset_C}{range_C \times accuracy_C} \right) \times \left( w_{1\_max} - w_{1\_min} \right)$$

where $w_1$ is the first offset component, $w_{1\_min}$ is a preset minimum value of the first offset component, $w_{1\_max}$ is a preset maximum value of the first offset component, $offset_c$ is the current offset, $range_c$ is a measurable maximum current of the current measurement specification, and $accuracy_c$ is a current measurement error of the current measurement specification.

The system noise calculation unit may be configured to calculate the second offset component using Equation 2 below,

[Equation 2]

$$w_2 = w_{2\_min} + \left( \frac{offset_V}{range_V \times accuracy_V} \right) \times \left( w_{2\_max} - w_{2\_min} \right)$$

where $w_2$ is the second offset component, $w_{2\_min}$ is a preset minimum value of the second offset component, $w_{2\_max}$ is a preset maximum value of the second offset component, $offset_v$ is the voltage offset, $range_v$ is a measurable maximum voltage of the voltage measurement specification, and $accuracy_v$ is a voltage measurement error of the voltage measurement specification.

The variance noise matrix may be configured as a matrix including a first variance component and a second variance component.

The system noise calculation unit may be configured to calculate the first variance component based on the current variance and the current measurement specification and calculate the second variance component based on the voltage offset and the voltage measurement specification.

The system noise calculation unit may be configured to calculate the first variance component using Equation 3 below,

[Equation 3]

$$q_{11} = q_{11\_min} + \left( \frac{var_C}{(range_C \times accuracy_C)^2} \right) \times \left( q_{11\_max} - q_{11\_min} \right)$$

where $q_{11}$ is the first variance component, $q_{11\_min}$ is a preset minimum value of the first variance component, $q_{11\_max}$ is a preset maximum value of the first variance component, $var_c$ is the current variance, $range_c$ is a measurable maximum current of the current measurement specification, and $accuracy_c$ is a current measurement error of the current measurement specification.

The system noise calculation unit may be configured to calculate the second variance component using Equation

4 below,

[Equation 4]

$$q_{22} = q_{22\_min} + \left( \frac{var_V}{(range_V \times accuracy_V)^2} \right) \times \left( q_{22\_max} - q_{22\_min} \right)$$

where $q_{22}$ is the second variance component, $q_{22\_min}$ is a preset minimum value of the second variance component, $q_{22\_max}$ is a preset maximum value of the second variance component, $var_V$ is the voltage variance, $range_V$ is a measurable maximum voltage of the voltage measurement specification, and $accuracy_V$ is a voltage measurement error of the voltage measurement specification.

The system noise calculation unit may be configured to calculate the system noise by calculating a dot product of the offset noise matrix, the variance noise matrix, and a transposition matrix of the offset noise matrix.

The system noise calculation unit may be configured to calculate the system noise using Equation 5 below,

[Equation 5]

$$\Sigma_w = WQW^T$$

where $\Sigma_w$ is the system noise, W is the offset noise matrix, $W^T$ is the transposed matrix of the offset noise matrix, and Q is the variance noise matrix.

The recursive filter may be configured as a dual adaptive extended Kalman filter including a first extended Kalman filter that predicts and corrects SOC and SOC covariance of the battery and a second extended Kalman filter that predicts and corrects SOH and SOH covariance of the battery.

The first extended Kalman filter may be configured to predict SOC of a current cycle based on SOC of the battery estimated in a previous cycle and the offset noise matrix, predict SOC covariance of the current cycle based on SOC covariance of the battery estimated in the previous cycle and the system noise, and estimate SOC and SOC covariance of the battery in the current cycle based on the predicted SOC, the predicted SOC covariance, and the SOH predicted by the second extended Kalman filter.

The second extended Kalman filter may be configured to predict SOH of a current cycle based on SOH of the battery estimated in a previous cycle, predict SOH covariance of the current cycle based on SOH covariance of the battery estimated in the previous cycle and the variance noise matrix, and estimate SOH and SOH covariance of the battery in the current cycle based on the predicted SOH, the predicted SOH covariance, and the SOC predicted by the first extended Kalman filter.

A battery pack according to another aspect of the present disclosure may comprise the battery state estimating apparatus according to an aspect of the present disclosure.

An energy storage system according to another aspect of the present disclosure may comprise the battery state estimating apparatus according to an aspect of the present disclosure.

A battery state estimating method according to another aspect of the present disclosure may comprise: a voltage and current obtaining step of obtaining a voltage value and a current value of a battery; an offset and variance calculating step of calculating a voltage offset and a voltage variance based on a voltage value of the battery obtained during a predetermined period and calculating a current offset and a current variance based on a current value of the battery obtained during the predetermined period; a noise matrix calculating step of calculating an offset noise matrix and a variance noise matrix based on the voltage offset, the voltage variance, a preset voltage measurement specification, the current offset, the current variance and a preset current measurement specification; a system noise calculating step of calculating a system noise from the offset noise matrix and the variance noise matrix; and a battery state information estimating step of estimating state information of the battery by applying the system noise to a preset recursive filter.

Advantageous Effects

According to one aspect of the present disclosure, since parameters used in an extended Kalman filter can be corrected in consideration of offset and variance of a current sensor and a voltage sensor, there is an advantage in that a battery state can be more accurately estimated.

The effects of the present disclosure are not limited to the above, and other effects not mentioned herein will be clearly understood by those skilled in the art from the appended claims.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram showing a flowchart of a conventional dual adaptive extended Kalman filter.
FIG. 2 is a diagram schematically showing a battery state estimating apparatus according to an embodiment of the present disclosure.
FIG. 3 is a diagram schematically showing an exemplary configuration of a battery pack according to another embodiment of the present disclosure.
FIG. 4 is a diagram schematically showing a battery state estimating method according to still another embodiment of the present disclosure.

## BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

FIG. 2 is a diagram schematically showing a battery state estimating apparatus 100 according to an embodiment of the present disclosure.

Referring to FIG. 2, the battery state estimating apparatus 100 may include an offset and variance calculation unit 110, a system noise calculation unit 120, and a battery state estimation unit 130.

The offset and variance calculation unit 110 may be configured to calculate a voltage offset and voltage variance based on a voltage value of the battery obtained for a predetermined period.

Here, the battery refers to one physically separable independent cell having a negative electrode terminal and a positive electrode terminal. For example, a lithium-ion battery or a lithium polymer cell may be regarded as the battery. In addition, the battery may refer to a battery module in which a plurality of cells are connected in series and/or in parallel.

Preferably, the battery may be in a no-load state. More preferably, the battery may be in a state in which an open circuit voltage (OCV) can be measured after a predetermined period has elapsed in a no-load state.

For example, the offset and variance calculation unit 110 may be communicatively connected to a voltage measuring unit that measures the voltage of the battery. Also, the offset and variance calculation unit 110 may receive the voltage value of the battery measured for a predetermined period from the voltage measuring unit. Here, the voltage value of the battery received by the offset and variance calculation unit 110 may be a plurality of voltage values measured by the voltage measuring unit for a predetermined period according to the voltage measurement cycle.

For example, it is assumed that the predetermined period is T1, the voltage measurement cycle is T2, and T1 is greater than T2. The offset and variance calculation unit 110 may obtain a plurality of voltage values measured in a T2 cycle during a T1 period. In addition, the offset and variance calculation unit 110 may calculate a plurality of offsets for the voltage measuring unit during the T1 period by calculating a difference between each of the plurality of voltage values measured during the T2 cycle and the corresponding predicted value. In addition, the offset and variance calculation unit 110 may calculate the variance of the plurality of calculated offsets as a voltage variance.

In general, the offset of the voltage measuring unit may follow a normal distribution based on 0. That is, in a normal case, the offset is 0 [V], and when the measured value of the voltage measuring unit and the predicted value of the offset and variance calculation unit 110 are different, the offset may be calculated as a value exceeding 0 [V].

For example, the offset and variance calculation unit 110 may calculate an offset for each of the plurality of voltage values obtained during a predetermined period, and determine the largest value among the plurality of calculated offsets as the voltage offset. As another example, the offset and variance calculation unit 110 may determine the average value of the plurality of calculated offsets as the voltage offset. Preferably, the offset and variance calculation unit 110 may determine an average value of the plurality of offsets as a voltage offset in order to determine a representative offset of the voltage measuring unit for the predetermined period as a voltage offset.

Also, the offset and variance calculation unit 110 may calculate a voltage variance by calculating a variance of the plurality of calculated offsets.

For example, it is assumed that the predetermined period is 1 hour and the voltage measurement cycle is 1 minute. The offset and variance calculation unit 110 may obtain a total of 60 voltage values for the predetermined period (1 hour). The offset and variance calculation unit 110 may calculate a total of 60 offsets by calculating the offset for each of 60 voltage values. Also, the offset and variance calculation unit 110 may determine a maximum value or an average value of 60 offsets as a voltage offset. Finally, the offset and variance calculation unit 110 may calculate the variance of 60 offsets to determine the voltage variance.

The offset and variance calculation unit 110 may be configured to calculate a current offset and a current variance based on the current value of the battery obtained for a predetermined period.

For example, the offset and variance calculation unit 110 may be communicatively connected to a current measuring unit that measures the current of the battery. Also, the offset and variance calculation unit 110 may receive the current value of the battery measured for a predetermined period from the current measuring unit. Here, the current value of the battery received by the offset and variance calculation unit 110 may be a plurality of current values measured by the current measuring unit for a predetermined period according to the current measurement cycle.

For example, it is assumed that the predetermined period is T1, the current measurement cycle is T2, and T1 is greater than T2. The offset and variance calculation unit 110 may obtain a plurality of current values measured in a T2 cycle during a T1 period. In addition, the offset and variance calculation unit 110 may calculate a plurality of offsets for the current measuring unit during the T1 period by calculating a difference between each of the plurality of current values measured in the T2 cycle and the corresponding predicted value. In addition, the offset and variance calculation unit 110 may calculate the variance of the plurality of calculated offsets as the current variance.

In general, the offset of the current measuring unit may follow a normal distribution based on 0. That is, in a normal case, the offset is 0 [mA], and when the measured value of the current measuring unit and the predicted value of the offset and variance calculation unit 110 are different, the offset may be calculated as a value exceeding 0 [mA]. For example, when the battery is in a no-load state, the predicted current value may be 0 [mA]. However, if leakage current occurs or a defect occurs in the current measuring unit, the measured current value may exceed 0 [mA]. In this case, the offset for the current measuring unit calculated by the offset and variance calculation unit 110 may exceed 0 [mA].

For example, the offset and variance calculation unit 110 may calculate an offset for each of the plurality of current values obtained during a predetermined period, and determine the largest value among the plurality of calculated offsets as the current offset. As another example, the offset and variance calculation unit 110 may determine the average value of the plurality of calculated offsets as the current offset. Preferably, the offset and variance calculation unit 110 may determine an average value of the plurality of offsets as a current offset in order to determine a representative offset of the current measuring unit for a predetermined period as a current offset.

In addition, the offset and variance calculation unit 110 may calculate the current variance by calculating the variance of the plurality of calculated offsets.

For example, it is assumed that the predetermined period is 60 minutes and the current measurement cycle is 1 minute. The offset and variance calculation unit 110 may obtain a total of 60 current values in 60 minutes. The offset and variance calculation unit 110 may calculate a total of 60 offsets by calculating the offset for each of 60 current values. Also, the offset and variance calculation unit 110 may determine a maximum value or an average value of 60 offsets as a current offset. Finally, the offset and variance calculation unit 110 may determine the current variance by calculating the variance of the 60 offsets.

The system noise calculation unit 120 may be configured to calculate an offset noise matrix and a variance noise matrix based on the voltage offset, the voltage variance, a preset voltage measurement specification, the current offset, the current variance and a preset current measurement specification.

Here, the preset voltage measurement specification may include a measurable maximum voltage of the voltage measuring unit and a voltage measurement error of the voltage measuring unit. For example, the maximum measurable voltage of the voltage measuring unit may be 5 V, and the voltage measurement error of the voltage measuring unit may be 5%.

Similarly, the preset current measurement specification may include a maximum current measurable by the current measuring unit and a current measurement error of the current measuring unit. For example, the maximum current measurable by the current measuring unit may be 100 A, and the current measurement error of the current measuring unit may be 5%.

The offset noise matrix may be configured as a matrix including a first offset component and a second offset component.

For example, the offset noise matrix may be a matrix having the following structure.

$$W = [w1 \; w2]$$

Here, W may be an offset noise matrix, w1 may be a first offset component, and w2 may be a second offset component.

Specifically, the system noise calculation unit 120 may be configured to calculate a first offset component based on the current offset and the current measurement specification. Also, the system noise calculation unit 120 may be configured to calculate a second offset component based on the voltage offset and the voltage measurement specifications. Specific Equations by which the system noise calculation unit 120 calculates the first offset component and the second offset component will be described later.

The variance noise matrix may be configured as a matrix including a first variance component and a second variance component.

For example, the variance noise matrix may be a matrix having the following structure.

$$Q = \begin{bmatrix} q11 & q12 \\ q21 & q22 \end{bmatrix}$$

Here, Q may be a variance noise matrix, q11 may be a first variance component, and q22 may be a second variance component. In general, q12 and q21 may have a value of 0.

The system noise calculation unit 120 may be configured to calculate a first variance component based on the current variance and the current measurement specification and calculate a second variance component based on the voltage offset and the voltage measurement specification. Specific Equations by which the system noise calculation unit 120 calculates the first variance component and the second variance component will be described later.

The system noise calculation unit 120 may be configured to calculate the system noise from the offset noise matrix and the variance noise matrix.

For example, the system noise may be calculated by calculating a dot product of the offset noise matrix and the variance noise matrix. A specific Equation by which the system noise calculation unit 120 calculates the system noise will be described later.

In other words, the system noise caused by the voltage measuring unit and the current measuring unit may be more accurately reflected by calculating the system noise used in the process of estimating SOC and SOH of the battery based on the voltage offset, the voltage variance, the preset voltage measurement specification, the current offset, the current variance, and the preset current measurement specification.

The battery state estimation unit 130 may be configured to estimate state information of the battery by applying the system noise to a preset recursive filter.

For example, the recursive filter may include a dual adaptive extended Kalman filter including a first extended Kalman filter that predicts and corrects SOC and SOC covariance of the battery and a second extended Kalman filter that predicts and corrects SOH and SOH covariance of the battery.

Specifically, the first extended Kalman filter may be configured to predict SOC of the current cycle based on SOC of the battery estimated in the previous cycle and the offset noise matrix, predict SOC covariance of the current cycle based on SOC covariance of the battery estimated in the previous cycle and the system noise, and estimate SOC and SOC covariance of the battery in the current cycle based on the predicted SOC, the predicted SOC covariance, and the SOH predicted by the second extended Kalman filter.

In addition, the second extended Kalman filter may be configured to predict SOH of the current cycle based on SOH of the battery estimated in the previous cycle, predict SOH covariance of the current cycle based on SOH covariance of the battery estimated in the previous cycle and the variance noise matrix, and estimate SOH and SOH covariance of the battery in the current cycle based on the predicted SOH, the predicted SOH covariance, and the SOC predicted by the first extended Kalman filter.

Since the details of the dual adaptive extended Kalman filter are described in Non-patent Literature 1, a detailed description thereof will be omitted.

The battery state estimation unit 130 may estimate state information of the battery by reflecting the system noise corresponding to noise of the voltage measuring unit and the current measuring unit.

Therefore, the battery state estimating apparatus 100 according to an embodiment of the present disclosure has an advantage of more accurately estimating the current state of the battery by using the system noise calculated based on the voltage value and the current value obtained during a predetermined period, without simply applying an arbitrary noise value following a multivariate normal distribution.

Meanwhile, the offset and variance calculation unit 110, the system noise calculation unit 120 and the battery state estimation unit 130 included in the battery state estimating apparatus 100 may optionally include an application-specific integrated circuit (ASIC), another chipset, a logic circuit, a register, a communication modem, and a data processing device, and the like, known in the art to execute various control logics disclosed below. Also, when the control logic is implemented as software, the offset and variance calculation unit 110, the system noise calculation unit 120 and the battery state estimation unit 130 may be implemented as a set of program modules. At this time, the program modules may be stored in a memory and executed by the offset and variance calculation unit 110, the system noise calculation unit 120 and the battery state estimation unit 130. The memory may be internal or external to the offset and variance calculation unit 110, the system noise calculation unit 120 and the battery state estimation unit 130 and may be connected to the offset and variance calculation unit 110, the system noise calculation unit 120 and the battery state estimation unit 130 by various well-known means.

In addition, the battery state estimating apparatus 100 may further include a storage unit 140. The storage unit 140 may store data necessary for operation and function of each component of the battery state estimating apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the offset and variance calculation unit 110, the system noise calculation unit 120 and the battery state estimation unit 130 are defined.

For example, the storage unit 140 may store voltage values and current values of the battery obtained during a predetermined period. In addition, the SOC and SOH of the previous cycle derived by the recursive filter may be stored.

Hereinafter, details of the system noise calculation unit 120 calculating an offset component, a variance component, and a system noise will be described in detail.

The system noise calculation unit 120 may be configured to calculate the first offset component using Equation 1 below.

[Equation 1]

$$w_1 = w_{1\_min} + \left( \frac{offset_C}{range_C \times accuracy_C} \right) \times \left( w_{1\_max} - w_{1\_min} \right)$$

Here, $w_1$ may be the first offset component, $w_{1\_min}$ may be a preset minimum value of the first offset component, $w_{1\_max}$ may be a preset maximum value of the first offset component, $offset_c$ may be the current offset, $range_c$ may be a measurable maximum current of the current measurement specification, and $accuracy_c$ may be a current measurement error of the current measurement specification.

For example, it is assumed that the minimum value ($w_{1\_min}$) of the first offset component is 1, the maximum value ($w_{1\_max}$) of the first offset component is 10, the measurable maximum current ($range_c$) is 100 A, and the current measurement error ($accurac_c$) is 5%.

If a current offset of 1 A is generated during the predetermined period, the first offset component may be calculated as 2.8. Specifically, the system noise calculation unit 120 may calculate the first offset component as 2.8 by calculating the Equation of "1 + { 1 ÷ (100 × 0.05) × (10 - 1)}".

The system noise calculation unit 120 may be configured to calculate the second offset component using Equation 2 below.

[Equation 2]

$$w_2 = w_{2\_min} + \left( \frac{offset_V}{range_V \times accuracy_V} \right) \times \left( w_{2\_max} - w_{2\_min} \right)$$

Here, $w_2$ may be the second offset component, $w_{2\_min}$ may be a preset minimum value of the second offset component, $w_{2\_max}$ may be a preset maximum value of the second offset component, $offset_v$ may be the voltage offset, $range_v$ may be a measurable maximum voltage of the voltage measurement specification, and $accuracy_v$ may be a voltage measurement error of the voltage measurement specification.

For example, it is assumed that the minimum value ($w_{2\_min}$) of the second offset component is 1, the maximum value ($w_{2\_max}$) of the second offset component is 10, the measurable maximum voltage ($range_v$) is 5 V, and the voltage measurement error ($accuracy_v$) is 5%.

If a voltage offset of 0.03 V is generated during the predetermined period, the second offset component may be calculated as 2.08. Specifically, the system noise calculation unit 120 may calculate the second offset component as 2.08 by calculating the Equation of "1 + {0.03 ÷ (5 × 0.05) × (10 - 1)}".

The system noise calculation unit 120 may be configured to calculate the first variance component using Equation 3 below.

[Equation 3]

$$q_{11} = q_{11\_min} + \left( \frac{var_C}{(range_C \times accuracy_C)^2} \right) \times \left( q_{11\_max} - q_{11\_min} \right)$$

Here, $q_{11}$ may be the first variance component, $q_{11\_min}$ may be a preset minimum value of the first variance component, $q_{11\_max}$ may be a preset maximum value of the first variance component, $var_c$ may be the current variance, $range_c$ may be a measurable maximum current of the current measurement specification, and $accuracy_c$ may be a current measurement error of the current measurement specification.

For example, it is assumed that the minimum value ($q_{11\_min}$) of the first variance component is 0.01, the maximum value ($q_{11\_max}$) of the first variance component is 0.1, the measurable maximum current ($range_c$) is 100 A, and the current measurement error ($accuracy_c$) is 5%.

If the current variance is 1 during the predetermined period, the first variance component may be calculated as 0.0136. Specifically, the system noise calculation unit 120 may calculate the first variance component as 0.0136 by calculating the Equation of "0.01 + {1 ÷ (100 × 0.05)² × (0.1 - 0.01)}".

The system noise calculation unit 120 may be configured to calculate the second variance component using Equation 4 below.

[Equation 4]

$$q_{22} = q_{22\_min} + \left( \frac{var_V}{(range_V \times accuracy_V)^2} \right) \times \left( q_{22\_max} - q_{22\_min} \right)$$

Here, $q_{22}$ may be the second variance component, $q_{22\_min}$ may be a preset minimum value of the second variance component, $q_{22\_max}$ may be a preset maximum value of the second variance component, $var_v$ may be the voltage variance, $range_v$ may be a measurable maximum voltage of the voltage measurement specification, and $accuracy_v$ may be a voltage measurement error of the voltage measurement specification.

For example, it is assumed that the minimum value ($q_{22\_min}$) of the second variance component is 0.01, the maximum value ($q_{22\_max}$) of the second variance component is 0.1, the measurable maximum voltage ($range_v$) is 5 V, and the voltage measurement error ($accuracy_v$) is 5%.

If the voltage variance is 0.03 during the predetermined period, the second variance component may be calculated as 0.0532. Specifically, the system noise calculation unit 120 may calculate the second variance component as 0.0532 by calculating the Equation of "0.01 + {0.03 ÷ (5×0.05)² × (0.1 - 0.01)}".

The system noise calculation unit 120 may be configured to calculate system noise by calculating a dot product of the offset noise matrix, the variance noise matrix, and a transposed matrix of the offset noise matrix.

Specifically, the system noise calculation unit 120 may be configured to calculate the system noise using Equation 5 below.

[Equation 5]

$$\Sigma_w = WQW^T$$

Here, $\Sigma w$ may be the system noise, W may be the offset noise matrix, $W^T$ may be the transposed matrix of the offset noise matrix, and Q may be the variance noise matrix.

For example, as in the previous embodiment, it is assumed that the first offset component ($w_1$) is 2.8, the second offset component ($w_2$) is 2.08, the first variance component ($q_{11}$) is 0.0136, and the second variance component ($q_{22}$) is 0.0532. The system noise calculation unit 120 may calculate the system noise as 0.33678848 by calculating a dot product of the offset noise matrix, the variance noise matrix, and a transposed matrix of the offset noise matrix.

Since the battery state estimating apparatus 100 according to an embodiment of the present disclosure calculates the system noise ($\Sigma w$) in consideration of noise for the voltage measuring unit and the current measuring unit, there is an advantage in that the accuracy of the estimation for the state (SOC and SOH) of the battery using the recursive filter may be dramatically improved.

Hereinafter, an embodiment in which the offset noise matrix, the variance noise matrix, and the system noise are applied to a recursive filter by the battery state estimation unit 130 will be described in detail.

First, the dual adaptive extended Kalman filter includes a first extended Kalman filter and a second extended Kalman filter. The first extended Kalman filter is a recursive filter that may predict SOC and SOC covariance in the time-update step and correct the predicted SOC and the predicted SOC covariance in the measurement-update step. The second extended Kalman filter is a recursive filter that may predict SOH and SOH covariance in the time-update step and correct the predicted SOH and the predicted SOH covariance in the measurement-update step.

In addition, in the following, "^ (hat)" means an estimated value, "-" means a value predicted in the time-update step, and "+" means a value corrected in the measurement-update step.

However, the parameters (P, x, u, A, $\theta$, and k) included in Equation 6 to Equation 8 below are defined in Non-patent Literature 1, and these parameters are widely used in the extended Kalman filter or the dual adaptive extended Kalman filter. Accordingly, detailed descriptions of the parameters (P, x, u, A, $\theta$, and k) are omitted below.

The battery state estimation unit 130 may predict SOH covariance of the battery in the second extended Kalman filter using Equation 6 below.

$$[\text{Equation 6}]$$

$$P^-_{\theta,k+1} = P^+_{\theta,k} + Q_k$$

Here, Equation 6 corresponds to Equation 12 of Non-patent Literature 1, and $Q_k$ is the variance noise matrix calculated by the system noise calculation unit 120 at the k time point.

The battery state estimation unit 130 may predict SOH covariance ( $P^-_{\theta,k+1}$ ) of the k+1 time point by adding the variance noise matrix ($Q_k$) calculated by system noise calculation unit 120 to the SOH covariance (SOH covariance that has undergone time-update and measurement-update at the k time point, $P^+_{\theta,k}$ ) determined by the second extended Kalman filter at the k time point.

Thereafter, the SOH covariance ( $P^-_{\theta,k+1}$ ) predicted by the battery state estimation unit 130 may be corrected according to Equation 16 of Non-patent Literature 1. Specifically, the predicted SOH covariance ( $P^-_{\theta,k+1}$ ) may be corrected according to Equation 16 of Non-patent Literature 1 to determine the SOH covariance ( $P^+_{\theta,k+1}$ ) of the k+1 time point.

That is, since the battery state estimation unit 130 predicts the SOH covariance ( $P^-_{\theta,k+1}$ ) by further considering the variance noise matrix ($Q_k$) in the time-update process of the second extended Kalman filter, the noise of the voltage measuring unit and the current measuring unit may be reflected in the predicted SOH covariance ( $P^-_{\theta,k+1}$ ).

Therefore, referring to Equation 16 of Non-patent Literature 1, the SOH ( $\hat{\theta}^+_{k+1}$ ) corrected based on the predicted SOH covariance ( $P^-_{\theta,k+1}$ ) may represent a more accurate SOH for the battery.

The battery state estimation unit 130 may predict SOC of the battery in the first extended Kalman filter using Equation 7 below.

[Equation 7]

$$\hat{x}_{k+1}^- = f\left(\hat{x}_k^+, u_k, \hat{\theta}_{k+1}^-\right) + W_k$$

Here, Equation 7 corresponds to Equation 13 of Non-patent Literature 1, and $W_k$ is an offset noise matrix calculated by the system noise calculation unit 120 at the k time point.

The battery state estimation unit 130 may predict the SOC ($\hat{x}_{k+1}^-$) of the k+1 time point by adding the offset noise matrix ($W_k$) calculated by the system noise calculation unit 120 to SOC (SOC that has undergone time-update and measurement-update at the k time point, $\hat{x}_k^+$) determined by the first extended Kalman filter determined at the k time point.

After that, the SOC ($\hat{x}_{k+1}^-$) predicted by the battery state estimation unit 130 may be corrected according to Equation 14 of Non-patent Literature 1. Specifically, the predicted SOC ($\hat{x}_{k+1}^-$) may be corrected according to Equation 14 of Non-patent Literature 1 to determine the SOC ($\hat{x}_{k+1}^+$) of the k+1 time point.

That is, since the battery state estimation unit 130 predicts SOC ($\hat{x}_{k+1}^-$) by further considering the offset noise matrix ($W_k$) in the time-update process of the first extended Kalman filter, the noise of the voltage measuring unit and the current measuring unit may be reflected in the predicted SOC ($\hat{x}_{k+1}^-$).

In addition, referring to Equation 14 of Non-patent Literature 1, the predicted SOC ($\hat{x}_{k+1}^-$) may be corrected in consideration of the predicted SOC covariance ($P_{x,k+1}^-$) described later. Therefore, the corrected SOC ($\hat{x}_{k+1}^+$) may represent a more accurate SOC for the battery.

The battery state estimation unit 130 may predict the SOC covariance of the battery in the first extended Kalman filter using Equation 8 below.

[Equation 8]

$$P_{x,k+1}^- = \hat{A}_k P_{x,k}^+ \hat{A}_k^T + \Sigma_w$$

Here, Equation 8 corresponds to Equation 13 of Non-patent Literature 1, and $\Sigma_w$ is the system noise calculated by the system noise calculation unit 120 at the k time point.

The battery state estimation unit 130 may predict the SOC covariance ($P_{x,k+1}^-$) of the k+1 time point by adding the system noise ($\Sigma_w$) calculated by the system noise calculation unit 120 to the SOC covariance (SOC covariance that has undergone time-update and measurement-update at the k time point, $P_{x,k}^+$) determined by the first extended Kalman filter at the k time point.

After that, the SOC covariance ($P_{x,k+1}^-$) predicted by the battery state estimation unit 130 may be corrected according to Equation 14 of Non-patent Literature 1. Specifically, the predicted SOC covariance ($P_{x,k+1}^-$) may be corrected according to Equation 14 of Non-patent Literature 1 to determine the SOC covariance ($P_{x,k+1}^+$) of the k+1 time point.

That is, since the battery state estimation unit 130 predicts SOC covariance ($P_{x,k+1}^-$) by further considering the system noise ($\Sigma_w$) in the time-update process of the first extended Kalman filter, the noise of the voltage measuring unit and the current measuring unit may be reflected in the predicted SOC covariance ( $P_{x,k+1}^{-}$ ).

Therefore, referring to Equation 14 of Non-patent Literature 1, the SOC ( $\hat{x}_{k+1}^{+}$ ) corrected based on the predicted SOC covariance ( $P_{x,k+1}^{-}$ ) may represent a more accurate SOC for the battery.

The battery state estimating apparatus 100 according to the present disclosure may be applied to a battery management system (BMS). That is, the BMS according to the present disclosure may include the battery state estimating apparatus 100 described above. In this configuration, at least some of components of the battery state estimating apparatus 100 may be implemented by supplementing or adding functions of the components included in a conventional BMS. For example, each component of the battery state estimating apparatus 100 may be implemented as components of the BMS.

In addition, the battery state estimating apparatus 100 according to the present disclosure may be provided to a battery pack. That is, the battery pack according to the present disclosure may include the above-described battery state estimating apparatus 100 and one or more battery cells. In addition, the battery pack may further include electrical components (a relay, a fuse and the like) and a case.

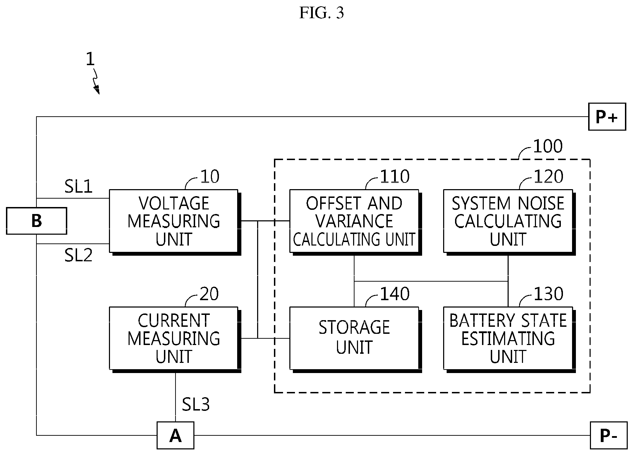

FIG. 3 is a diagram schematically showing an exemplary configuration of a battery pack according to another embodiment of the present disclosure.

Referring to FIG. 3, the battery pack 1 may include a battery B, a voltage measuring unit 10, a current measuring unit 20, and a battery state estimating apparatus 100.

The positive electrode terminal of the battery B may be connected to the positive electrode terminal P+ of the battery pack 1, and the negative electrode terminal of the battery B may be connected to the negative electrode terminal P- of the battery pack 1.

The voltage measuring unit 10 may be connected to the first sensing line SL1 and the second sensing line SL2.

Specifically, the voltage measuring unit 10 may be connected to the positive electrode terminal of the battery B through the first sensing line SL1, and may be connected to the negative electrode terminal of the battery B through the second sensing line SL2. The voltage measuring unit 10 may measure the voltage of the battery B based on the voltage measured at each of the first sensing line SL1 and the second sensing line SL2.

The current measuring unit 20 may be connected to a third sensing line SL3.

In addition, the current measuring unit 20 may be connected to the current measuring unit A through the third sensing line SL3. For example, the current measuring unit A may be an ammeter or a shunt resistor provided on the charging and discharging path of the battery B and capable of measuring a current of the charging and discharging path. The current measuring unit 20 may measure the charging current of the battery B through the third sensing line SL3.

The offset and variance calculation unit 110 may receive the voltage value of the battery B from the voltage measuring unit 10. In addition, the offset and variance calculation unit 110 may receive the current value of the battery B from the current measuring unit 20.

In addition, among the current measurement specifications used to calculate the first offset component ($w_1$) of Equation 1 and the first variance component ($q_{11}$) of Equation 3, the measurable maximum current ($range_c$) may be a maximum current value measurable by the current measuring unit 20. For example, the maximum current value measurable by the current measuring unit 20 may be 100 A. Also, among the current measurement specifications, the current measurement error ($accuracy_c$) may be the current measurement error of the current measuring unit 20. For example, the current measurement error of the current measuring unit 20 may be 5%.

In addition, among the voltage measurement specifications used to calculate the second offset component ($w_2$) of Equation 2 and the second variance component ($q_{22}$) of Equation 4, the measurable maximum voltage ($range_v$) may be a maximum voltage value measurable by the voltage measuring unit 10. For example, the maximum voltage value measurable by the voltage measuring unit 10 may be 5 V. Also, among the voltage measurement specifications, the voltage measurement error ($accuracy_v$) may be the voltage measurement error of the voltage measuring unit 10. For example, the voltage measurement error of the voltage measuring unit 10 may be 5%.

Referring to FIG. 3, the voltage value measured by the voltage measuring unit 10 and the current value measured by the current measuring unit 20 may be directly transmitted to the offset and variance calculation unit 110 or may be stored in the storage unit 140. When the voltage value and current value are stored in the storage unit 140, the offset and variance calculation unit 110 may access the storage unit 140 to obtain the voltage value and the current value for a predetermined period.

An energy storage system (ESS) according to still another embodiment of the present disclosure may include the battery state estimating apparatus 100 according to an embodiment of the present disclosure.

The energy storage system is a storage system including a plurality of battery racks, and the battery rack may include a plurality of battery packs. The battery pack may be composed of a plurality of battery modules, and the battery module may be composed of a plurality of battery cells.

The battery state estimating apparatus 100 may be provided for each battery rack and/or battery pack constituting the energy storage system.

For example, the battery state estimating apparatus 100 may be provided for each battery rack constituting the energy storage system, and may calculate system noise for the corresponding battery rack. In addition, the battery state estimating apparatus 100 may estimate the state of the battery pack using the recursive filter and the calculated system noise (commonly applied to a plurality of battery packs included in the battery rack).

As another example, the battery state estimating apparatus 100 may be provided for each battery pack constituting the battery rack and calculate system noise for the corresponding battery pack. In addition, the battery state estimating apparatus 100 may estimate the state of the battery pack using the recursive filter and the calculated system noise (applied to each battery pack).

Preferably, when the battery state estimating apparatus 100 calculates system noise for each battery cell, which is the minimum unit constituting the energy storage system, the state of the battery cell, the battery module, the battery pack, and the battery rack may be more accurately estimated. However, since it is practically impossible to have the battery state estimating apparatus 100 in every battery cell constituting the energy storage system, the battery state estimating apparatus 100 may be provided in each battery rack or each battery pack to estimate the state of the battery pack.

In the above, an embodiment in which the battery state estimating apparatus 100 is provided in a battery rack and/or a battery pack has been described due to a practical problem that all battery cells constituting the energy storage system cannot be provided with the battery state estimating apparatus 100. However, it should be noted that an embodiment in which the battery state estimating apparatus 100 is provided for each battery cell or each battery module is not limited by this description.

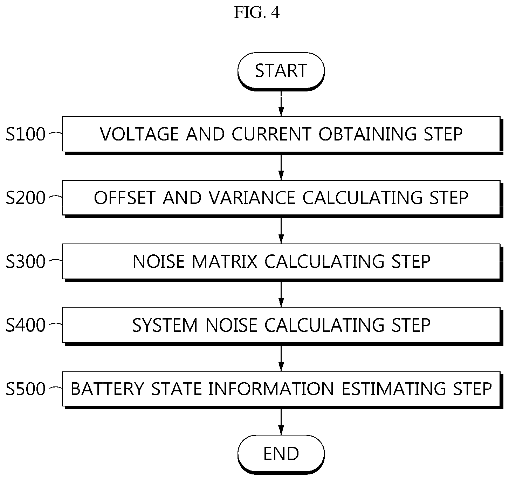

FIG. 4 is a diagram schematically showing a battery state estimating method according to still another embodiment of the present disclosure.

Preferably, each step of the battery state estimating method may be performed by the battery state estimating apparatus 100. Hereinafter, the content overlapping with the previously described content will be briefly described or omitted.

Referring to FIG. 4, the battery state estimating method may include a voltage and current obtaining step (S100), an offset and variance calculating step (S200), a noise matrix calculating step (S300), a system noise calculating step (S400) and a battery state information estimating step (S500).

The voltage and current obtaining step (S100) is a step of obtaining a voltage value and a current value of a battery, and may be performed by the offset and variance calculation unit 110.

Here, the voltage and current obtained by the offset and variance calculation unit 110 may be a voltage value and a current value of a battery in a no-load state.

For example, in the embodiment of FIG. 3, the offset and variance calculation unit 110 may receive the voltage value of the battery B from the voltage measuring unit 10 and the current value of the battery B from the current measuring unit 20.

As another example, in the embodiment of FIG. 3, the storage unit 140 may receive and store the voltage value of the battery B from the voltage measuring unit 10 and receive and store the current value of the battery B from the current measuring unit 20. The offset and variance calculation unit 110 may access the storage unit 140 to obtain the voltage value and the current value of the battery B.

The offset and variance calculating step (S200) is a step of calculating a voltage offset and a voltage variance based on the voltage value of the battery obtained during a predetermined period and calculating a current offset and a current variance based on the current value of the battery obtained during the predetermined period, and may be performed by the offset and variance calculation unit 110.

For example, in the embodiment of FIG. 3, the offset and variance calculation unit 110 may calculate an offset of the voltage measuring unit 10 based on a plurality of voltage values measured by the voltage measuring unit 10 for a predetermined period. Also, the offset and variance calculation unit 110 may calculate a maximum value or an average value of the plurality of calculated offsets as a voltage offset. In addition, the offset and variance calculation unit 110 may calculate the variance of the plurality of calculated offsets as the voltage variance.

Also, in the embodiment of FIG. 3, the offset and variance calculation unit 110 may calculate an offset of the current measuring unit 20 based on a plurality of current values measured by the current measuring unit 20 during a predetermined period. Also, the offset and variance calculation unit 110 may calculate a maximum value or an average value among the plurality of calculated offsets as a current offset. In addition, the offset and variance calculation unit 110 may calculate the variance of the plurality of offsets as the current variance.

The noise matrix calculating step (S300) is a step of calculating an offset noise matrix and a variance noise matrix based on the voltage offset, the voltage variance, a preset voltage measurement specification, the current offset, the current variance, and a preset current measurement specification, and may be performed by the system noise calculation unit 120.

For example, the system noise calculation unit 120 may calculate the first offset component ($w_1$) based on the

current offset, the current variance, and the current measurement specification according to Equation 1. In addition, the system noise calculation unit 120 may calculate the second offset component ($w_2$) based on the voltage offset, the voltage variance, and the voltage measurement specification according to Equation 2. Also, the system noise calculation unit 120 may determine an offset noise matrix (W) including the first offset component ($w_1$) and the second offset component ($w_2$).

In addition, the system noise calculation unit 120 may calculate the first variance component ($q_{11}$) based on the current offset, the current variance, and the current measurement specification according to Equation 3. In addition, the system noise calculation unit 120 may calculate the second variance component ($q_{22}$) based on the voltage offset, the voltage variance, and the voltage measurement specification according to Equation 4. Also, the system noise calculation unit 120 may determine a variance noise matrix (Q) including the first variance component ($q_{11}$) and the second variance component (q22).

The system noise calculating step (S400) is a step of calculating system noise from the offset noise matrix and the variance noise matrix, and may be performed by the system noise calculation unit 120.

For example, the system noise calculation unit 120 may calculate the system noise ($\Sigma_w$) by calculating a dot product of the offset noise matrix (W), the variance noise matrix (Q), and a transposed matrix ($W^T$) of the offset noise matrix (W) according to Equation 5.

The battery state information estimating step (S500) is a step of estimating state information of the battery by applying the system noise to a preset recursive filter, and may be performed by the battery state estimation unit 130.

For example, the battery state estimation unit 130 may further add the offset noise matrix (W) to the SOC predicting process of the first extended Kalman filter.

In addition, the battery state estimation unit 130 may further add the system noise ($\Sigma_w$) to the SOC covariance predicting process of the first extended Kalman filter.

In addition, the battery state estimation unit 130 may further add the variance noise matrix (Q) to the SOH covariance predicting process of the second extended Kalman filter.

The battery state estimation unit 130 has an advantage of more accurately estimating SOC and SOH of the battery by using the offset noise matrix (W), the variance noise matrix (Q), and the system noise ($\Sigma_w$).

The embodiments of the present disclosure described above may not be implemented only through an apparatus and method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

In addition, since the present disclosure described above can be substituted, modified and changed in various ways by those skilled in the art without departing from the technical idea of the present disclosure, the present disclosure is not limited by the embodiments described above and the accompanying drawings, and all or some of the embodiments may be selectively combined to enable various modifications.

(Explanation of reference signs)

    1: battery pack
    10: voltage measuring unit
    20: current measuring unit
    100: battery state estimating apparatus
    110: offset and variance calculation unit
    120: system noise calculation unit
    130: battery state estimation unit
    140: storage unit

**Claims**

1.  A battery state estimating apparatus (100), comprising:

    an offset and variance calculation unit (110) configured to calculate a voltage offset and a voltage variance based on a voltage value of a battery obtained during a predetermined period and calculate a current offset and a current variance based on a current value of the battery obtained during the predetermined period;
a system noise calculation unit (120) configured to calculate an offset noise matrix and a variance noise matrix based on the voltage offset, the voltage variance, a preset voltage measurement specification, the current offset, the current variance and a preset current measurement specification and calculate a system noise from the offset noise matrix and the variance noise matrix; and
a battery state estimation unit (130) configured to estimate state information of the battery by applying the system noise to a preset recursive filter.

2. The battery state estimating apparatus according to claim 1,

wherein the offset noise matrix is configured as a matrix including a first offset component and a second offset component, and
wherein the system noise calculation unit is configured to calculate the first offset component based on the current offset and the current measurement specification and calculate the second offset component based on the voltage offset and the voltage measurement specification.

3. The battery state estimating apparatus according to claim 2,

wherein the system noise calculation unit is configured to calculate the first offset component using Equation 1 below,

[Equation 1]

$$w_1 = w_{1\_min} + \left( \frac{offset_C}{range_C \times accuracy_C} \right) \times \left( w_{1\_max} - w_{1\_min} \right)$$

where $w_1$ is the first offset component, $w_{1\_min}$ is a preset minimum value of the first offset component, $w_{1\_max}$ is a preset maximum value of the first offset component, $offset_c$ is the current offset, $range_c$ is a measurable maximum current of the current measurement specification, and $accuracy_c$ is a current measurement error of the current measurement specification.

4. The battery state estimating apparatus according to claim 2,

wherein the system noise calculation unit is configured to calculate the second offset component using Equation 2 below,

[Equation 2]

$$w_2 = w_{2\_min} + \left( \frac{offset_V}{range_V \times accuracy_V} \right) \times \left( w_{2\_max} - w_{2\_min} \right)$$

where $w_2$ is the second offset component, $w_{2\_min}$ is a preset minimum value of the second offset component, $w_{2\_max}$ is a preset maximum value of the second offset component, $offset_v$ is the voltage offset, $range_v$ is a measurable maximum voltage of the voltage measurement specification, and $accuracy_v$ is a voltage measurement error of the voltage measurement specification.

5. The battery state estimating apparatus according to claim 1,

wherein the variance noise matrix is configured as a matrix including a first variance component and a second variance component, and
wherein the system noise calculation unit is configured to calculate the first variance component based on the current variance and the current measurement specification and calculate the second variance component based on the voltage offset and the voltage measurement specification.

6. The battery state estimating apparatus according to claim 5,

   wherein the system noise calculation unit is configured to calculate the first variance component using Equation 3 below,

   [Equation 3]

   $$q_{11} = q_{11\_min} + \left( \frac{var_C}{(range_C \times accuracy_C)^2} \right) \times \left( q_{11\_max} - q_{11\_min} \right)$$

   where $q_{11}$ is the first variance component, $q_{11\_min}$ is a preset minimum value of the first variance component, $q_{11\_max}$ is a preset maximum value of the first variance component, $var_c$ is the current variance, $range_c$ is a measurable maximum current of the current measurement specification, and $accuracy_c$ is a current measurement error of the current measurement specification.

7. The battery state estimating apparatus according to claim 5,

   wherein the system noise calculation unit is configured to calculate the second variance component using Equation 4 below,

   [Equation 4]

   $$q_{22} = q_{22\_min} + \left( \frac{var_V}{(range_V \times accuracy_V)^2} \right) \times \left( q_{22\_max} - q_{22\_min} \right)$$

   where $q_{22}$ is the second variance component, $q_{22\_min}$ is a preset minimum value of the second variance component, $q_{22\_max}$ is a preset maximum value of the second variance component, $var_v$ is the voltage variance, $range_v$ is a measurable maximum voltage of the voltage measurement specification, and $accuracy_v$ is a voltage measurement error of the voltage measurement specification.

8. The battery state estimating apparatus according to claim 1,
   wherein the system noise calculation unit is configured to calculate the system noise by calculating a dot product of the offset noise matrix, the variance noise matrix, and a transposition matrix of the offset noise matrix.

9. The battery state estimating apparatus according to claim 8,

   wherein the system noise calculation unit is configured to calculate the system noise using Equation 5 below,

   [Equation 5]

   $$\Sigma_w = WQW^T$$

   where $\Sigma_w$ is the system noise, W is the offset noise matrix, $W^T$ is the transposed matrix of the offset noise matrix, and Q is the variance noise matrix.

10. The battery state estimating apparatus according to claim 1,
    wherein the recursive filter is configured as a dual adaptive extended Kalman filter including a first extended Kalman filter that predicts and corrects SOC and SOC covariance of the battery and a second extended Kalman filter that predicts and corrects SOH and SOH covariance of the battery.

11. The battery state estimating apparatus according to claim 10,
    wherein the first extended Kalman filter is configured to predict SOC of a current cycle based on SOC of the battery estimated in a previous cycle and the offset noise matrix, predict SOC covariance of the current cycle based on SOC covariance of the battery estimated in the previous cycle and the system noise, and estimate SOC and SOC covariance of the battery in the current cycle based on the predicted SOC, the predicted SOC covariance, and the SOH predicted by the second extended Kalman filter.

12. The battery state estimating apparatus according to claim 10,
wherein the second extended Kalman filter is configured to predict SOH of a current cycle based on SOH of the battery estimated in a previous cycle, predict SOH covariance of the current cycle based on SOH covariance of the battery estimated in the previous cycle and the variance noise matrix, and estimate SOH and SOH covariance of the battery in the current cycle based on the predicted SOH, the predicted SOH covariance, and the SOC predicted by the first extended Kalman filter.

13. A battery pack (1), comprising the battery state estimating apparatus according to any one of claims 1 to 12.

14. An energy storage system, comprising the battery state estimating apparatus according to any one of claims 1 to 12.

15. A battery state estimating method, comprising:

a voltage and current obtaining step of obtaining a voltage value and a current value of a battery;
an offset and variance calculating step of calculating a voltage offset and a voltage variance based on a voltage value of the battery obtained during a predetermined period and calculating a current offset and a current variance based on a current value of the battery obtained during the predetermined period;
a noise matrix calculating step of calculating an offset noise matrix and a variance noise matrix based on the voltage offset, the voltage variance, a preset voltage measurement specification, the current offset, the current variance and a preset current measurement specification;
a system noise calculating step of calculating a system noise from the offset noise matrix and the variance noise matrix; and
a battery state information estimating step of estimating state information of the battery by applying the system noise to a preset recursive filter.

**Patentansprüche**

1. Batteriezustands-Schätzungsvorrichtung (100), umfassend:

eine Offset- und Varianz-Berechnungseinheit (110), welche dazu eingerichtet ist, einen Spannungsoffset und eine Spannungsvarianz auf Grundlage eines Spannungswertes einer Batterie zu berechnen, welcher während einer vorbestimmten Periode erhalten ist, und einen Stromoffset und eine Stromvarianz auf Grundlage eines Stromwertes der Batterie zu berechnen, welcher während der vorbestimmten Periode erhalten ist;
eine Systemstörungs-Berechnungseinheit (120), welche dazu eingerichtet ist, eine Offset-Störungsmatrix und eine Varianz-Störungsmatrix auf Grundlage des Spannungsoffsets, der Spannungsvarianz, einer vorfestgelegten Spannungsmessungsspezifikation, des Stromoffsets, der Stromvarianz und einer vorfestgelegten Strommessungsspezifikation zu berechnen und eine Systemstörung von der Offset-Störungsmatrix und der Varianz-Störungsmatrix zu berechnen; und
eine Batteriezustands-Schätzungseinheit (130), welche dazu eingerichtet ist, Zustandsinformationen der Batterie durch Anwenden der Systemstörung auf einen vorfestgelegten rekursiven Filter zu schätzen.

2. Batteriezustands-Schätzungsvorrichtung nach Anspruch 1,

wobei die Offset-Störungsmatrix als eine Matrix eingerichtet ist, welche eine erste Offset-Komponente und eine zweite Offset-Komponente umfasst, und
wobei die Systemstörungs-Berechnungseinheit dazu eingerichtet ist, die erste Offset-Komponente auf Grundlage des Stromoffsets und der Strommessungsspezifikation zu berechnen und die zweite Offset-Komponente auf Grundlage des Spannungsoffsets und der Spannungsmessungsspezifikation zu berechnen.

3. Batteriezustands-Schätzungsvorrichtung nach Anspruch 2, wobei die Systemstörungs-Berechnungseinheit dazu eingerichtet ist, die erste Offset-Komponente unter Verwendung der Formel 1 unten zu berechnen,

[Formel 1]

$$w_1 = w_{1\_min} + \left( \frac{offset_c}{range_c \times accuracy_c} \right) \times \left( w_{1\_max} - w_{1\_min} \right)$$

wobei $w_1$ die erste Offset-Komponente ist, $w_{1\_min}$ ein vorfestgelegter Minimalwert der ersten Offset-Komponente ist, $w_{1\_max}$ ein vorfestgelegter Maximalwert der ersten Offset-Komponente ist, $offset_c$ der Stromoffset ist, $range_c$ ein messbarer Maximalstrom der Strommessungsspezifikation ist, und $accuracy_c$ ein Strommessungsfehler der Strommessungsspezifikation ist.

4. Batteriezustands-Schätzungsvorrichtung nach Anspruch 2, wobei die Systemstörungs-Berechnungseinheit dazu eingerichtet ist, die zweite Offset-Komponente unter Verwendung der Formel 2 unten zu berechnen,

[Formel 2]

$$w_2 = w_{2\_min} + \left( \frac{offset_v}{range_v \times accuracy_v} \right) \times \left( w_{2\_max} - w_{2\_min} \right)$$

wobei $w_2$ die zweite Offset-Komponente ist, $w_{2\_min}$ ein vorfestgelegter Minimalwert der zweiten Offset-Komponente ist, $w_{2\_max}$ ein vorfestgelegter Maximalwert der zweiten Offset-Komponente ist, $offset_v$ der Spannungsoffset ist, $range_v$ eine messbare Maximalspannung der Spannungsmessungsspezifikation ist, und $accuracy_v$ ein Spannungsmessungsfehler der Spannungsmessungsspezifikation ist.

5. Batteriezustands-Schätzungsvorrichtung nach Anspruch 1,

wobei die Varianz-Störungsmatrix als eine Matrix eingerichtet ist, welche eine erste Varianz-Komponente und eine zweite Varianz-Komponente umfasst, und
wobei die Systemstörungs-Berechnungseinheit dazu eingerichtet ist, die erste Varianz-Komponente auf Grundlage der Stromvarianz und der Strommessungsspezifikation zu berechnen und die zweite Varianz-Komponente auf Grundlage des Spannungsoffsets und der Spannungsmessungsspezifikation zu berechnen.

6. Batteriezustands-Schätzungsvorrichtung nach Anspruch 5, wobei die Systemstörungs-Berechnungseinheit dazu eingerichtet ist, die erste Varianz-Komponente unter Verwendung der Formel 3 unten zu berechnen,

[Formel 3]

$$q_{11} = q_{11\_min} + \left( \frac{var_c}{(range_c \times accuracy_c)^2} \right) \times \left( q_{11\_max} - q_{11\_min} \right)$$

wobei $q_{11}$ die erste Varianz-Komponente ist, $q_{11\_min}$ ein vorfestgelegter Minimalwert der ersten Varianz-Komponente ist, $q_{11\_max}$ ein vorfestgelegter Maximalwert der ersten Varianz-Komponente ist, $var_c$ die Stromvarianz ist, $range_c$ ein messbarer Maximalstrom der Strommessungsspezifikation ist, und $accuracy_c$ ein Strommessungsfehler der Strommessungsspezifikation ist.

7. Batteriezustands-Schätzungsvorrichtung nach Anspruch 5, wobei die Systemstörungs-Berechnungseinheit dazu eingerichtet ist, die zweite Varianz-Komponente unter Verwendung der Formel 4 unten zu berechnen,

[Formel 4]

$$q_{22} = q_{22\_min} + \left( \frac{var_v}{(range_v \times accuracy_v)^2} \right) \times \left( q_{22\_max} - q_{22\_min} \right)$$

wobei $q_{22}$ die zweite Varianz-Komponente ist, $q_{22\_min}$ ein vorfestgelegter Minimalwert der zweiten Varianz-Komponente ist, $q_{22\_max}$ ein vorfestgelegter Maximalwert der zweiten Varianz-Komponente ist, $var_v$ die Spannungsvarianz ist, $range_v$ eine messbare Maximalspannung der Spannungsmessungsspezifikation ist, und $accuracy_v$ ein

Spannungsmessungsfehler der Spannungsmessungsspezifikation ist.

8. Batteriezustands-Schätzungsvorrichtung nach Anspruch 1, wobei die Systemstörungs-Berechnungseinheit dazu eingerichtet ist, die Systemstörung durch Berechnen eines Skalarprodukts der Offset-Störungsmatrix, der Varianz-Störungsmatrix und einer Transpositionsmatrix der Offset-Störungsmatrix zu berechnen.

9. Batteriezustands-Schätzungsvorrichtung nach Anspruch 8, wobei die Systemstörungs-Berechnungseinheit dazu eingerichtet ist, die Systemstörung unter Verwendung der Formel 5 unten zu berechnen,

[Formel 5]

$$\Sigma_w = WQW^T$$

wobei $\Sigma_w$ die Systemstörung ist, W die Offset-Störungsmatrix ist, $W^T$ die transponierte Matrix der Offset-Störungsmatrix ist, und Q die Varianz-Störungsmatrix ist.

10. Batteriezustands-Schätzungsvorrichtung nach Anspruch 1, wobei der rekursive Filter als ein dualadaptiver erweiterter Kalman-Filter eingerichtet ist, welcher einen ersten erweiterten Kalman-Filter, welcher einen SOC und eine SOC-Kovarianz der Batterie voraussagt und korrigiert, und einen zweiten erweiterten Kalman-Filter umfasst, welcher einen SOH und eine SOH-Kovarianz der Batterie voraussagt und korrigiert.

11. Batteriezustands-Schätzungsvorrichtung nach Anspruch 10, wobei der erste erweiterte Kalman-Filter dazu eingerichtet ist, einen SOC eines aktuellen Zyklus auf Grundlage eines SOC der Batterie, welcher in einem vorherigen Zyklus geschätzt ist, und der Offset-Störungsmatrix vorauszusagen, eine SOC-Kovarianz des aktuellen Zyklus auf Grundlage der SOC-Kovarianz der Batterie, welche in dem vorherigen Zyklus geschätzt ist, und der Systemstörung vorauszusagen, eine SOC und SOC-Kovarianz der Batterie in dem aktuellen Zyklus auf Grundlage des vorausgesagten SOC, der vorausgesagten SOC-Kovarianz und des SOH zu schätzen, welcher durch den zweiten erweiterten Kalman-Filter vorausgesagt ist.

12. Batteriezustands-Schätzungsvorrichtung nach Anspruch 10, wobei der zweite erweiterte Kalman-Filter dazu eingerichtet ist, einen SOH eines aktuellen Zyklus auf Grundlage eines SOH der Batterie vorauszusagen, welcher in einem vorherigen Zyklus geschätzt ist, eine SOH-Kovarianz des aktuellen Zyklus auf Grundlage der SOH-Kovarianz der Batterie, welche in dem vorherigen Zyklus geschätzt ist, und der Varianz-Störungsmatrix vorauszusagen, und einen SOH und eine SOH-Kovarianz der Batterie in dem aktuellen Zyklus auf Grundlage des vorausgesagten SOH, der vorausgesagten SOH-Kovarianz und des SOC zu schätzen, welcher durch den ersten erweiterten Kalman-Filter vorausgesagt ist.

13. Batteriepackung (1), umfassend die Batteriezustands-Schätzungsvorrichtung nach einem der Ansprüche 1 bis 12.

14. Energiespeichersystem, umfassend die Batteriezustands-Schätzungsvorrichtung nach einem der Ansprüche 1 bis 12.

15. Batteriezustands-Schätzungsverfahren, umfassend:

einen Spannungs- und Stromerhaltungsschritt eines Erhaltens eines Spannungswertes und eines Stromwertes einer Batterie;
einen Offset- und Varianzberechnungsschritt eines Berechnens eines Spannungsoffsets und einer Spannungsvarianz auf Grundlage eines Spannungswertes der Batterie, welcher während einer vorbestimmten Periode erhalten wird, und eines Berechnens eines Stromoffsets und einer Stromvarianz auf Grundlage eines Stromwertes der Batterie, welcher während der vorbestimmten Periode erhalten wird;
einen Störungsmatrixberechnungsschritt eines Berechnens einer Offset-Störungsmatrix und einer Varianz-Störungsmatrix auf Grundlage des Spannungsoffsets, der Spannungsvarianz, einer vorfestgelegten Spannungsmessungsspezifikation, des Stromoffsets, der Stromvarianz und einer vorfestgelegten Strommessungsspezifikation;
einen Systemstörungsberechnungsschritt eines Berechnens einer Systemstörung aus der Offsetstörungsmatrix und der Varianzstörungsmatrix; und
einen Batteriezustandsinformationenschätzungsschritt eines Schätzens von Zustandsinformationen der Batterie durch Anwenden der Systemstörung auf einen vorfestgelegten rekursiven Filter.

**Revendications**

1. Appareil (100) d'estimation de l'état d'une batterie, comprenant :

   une unité de calcul de décalage et de variance (110)
   configurée pour calculer un décalage de tension et une
   variance de tension sur la base d'une valeur de tension d'une batterie obtenue pendant une période prédéterminée et calculer un décalage de courant et une variance de courant sur la base d'une valeur de courant de la batterie obtenue pendant la période prédéterminée ;
   une unité de calcul de bruit système (120)
   configurée pour calculer une matrice de bruit de décalage et une
   matrice de bruit de variance sur la base du décalage de tension, de la variance de tension, d'une spécification de mesure de tension prédéfinie, du décalage de courant, de la variance de courant et d'une spécification de mesure de courant prédéfinie et calculer un bruit de système à partir de la matrice de bruit de décalage et de la matrice de bruit de variance ; et
   une unité d'estimation d'état de batterie (130)
   configurée pour estimer des informations d'état de la batterie
   en appliquant le bruit de système à un filtre récursif prédéfini.

2. Appareil d'estimation de l'état d'une batterie selon la revendication 1,

   dans lequel la matrice de bruit de décalage est configurée sous la forme d'une matrice comportant une première composante de décalage et une seconde composante de décalage, et
   dans lequel l'unité de calcul de bruit de système est configurée pour calculer la première composante de décalage sur la base du décalage de courant et de la spécification de mesure de courant et calculer la seconde composante de décalage sur la base du décalage de tension et de la spécification de mesure de tension.

3. Appareil d'estimation de l'état d'une batterie selon la revendication 2,

   dans lequel l'unité de calcul de bruit de système est configurée pour calculer la première composante de décalage à l'aide de l'équation 1 ci-dessous,

   [Équation 1]

   $$w_1 = w_{1\_min} + \left( \frac{offset_C}{range_C \times accuracy_c} \right) \times ( w_{1\_max} - w_{1\_min} )$$

   où $w_1$ est la première composante de décalage, $w_{1\_min}$ est une valeur minimale prédéfinie de la première composante de décalage, $w_{1\_max}$ est une valeur maximale prédéfinie de la première composante de décalage, $offset_c$ est le décalage de courant, $range_c$ est un courant maximal mesurable de la spécification de mesure de courant et la $accuracy_c$ est une erreur de mesure de courant de la spécification de mesure de courant.

4. Appareil d'estimation de l'état d'une batterie selon la revendication 2,

   dans lequel l'unité de calcul de bruit de système est configurée pour calculer la seconde composante de décalage à l'aide de l'équation 2 ci-dessous,

[Équation 2]

$$w_2 = w_{2\_min} + \left( \frac{offset_v}{range_v \times accuracy_v} \right) \times (w_{2\_max} - w_{2\_min})$$

où $w_2$ est la seconde composante de décalage, $W_{2\_min}$ est une valeur minimale prédéfinie de la seconde composante de décalage, $W_{2\_max}$ est une valeur maximale prédéfinie de la seconde composante de décalage, $offset_v$ est le décalage de tension, $range_v$ est une tension maximale mesurable de la spécification de mesure de tension, et $accuracy_v$ est une erreur de mesure de tension de la spécification de mesure de tension.

5. Appareil d'estimation de l'état d'une batterie selon la revendication 1,

dans lequel la matrice de bruit de variance est configurée sous la forme d'une matrice comportant une première composante de variance et une seconde composante de variance, et
dans lequel l'unité de calcul de bruit de système est configurée pour calculer la première composante de variance sur la base de la variance de courant et de la spécification de mesure de courant et calculer la seconde composante de variance sur la base du décalage de tension et de la spécification de mesure de tension.

6. Appareil d'estimation de l'état d'une batterie selon la revendication 5,

dans lequel l'unité de calcul de bruit de système est configurée pour calculer la première composante de variance à l'aide de l'équation 3 ci-dessous,

[Équation 3]

$$q_{11} = q_{11\_min} + \left( \frac{var_c}{(range_c \times accuracy_c)^2} \right) \times (q_{11\_max} - q_{11\_min})$$

où $q_{11}$ est la première composante de variance, $q_{11\_min}$ est une valeur minimale prédéfinie de la première composante de variance, $q_{11\_max}$ est une valeur maximale prédéfinie de la première composante de variance, $var_c$ est la variance de courant, $range_c$ est un courant maximal mesurable de la spécification de mesure de courant, et $accuracy_c$ est une erreur de mesure de courant de la spécification de mesure de courant.

7. Appareil d'estimation de l'état d'une batterie selon la revendication 5,

dans lequel l'unité de calcul de bruit de système est configurée pour calculer la seconde composante de variance à l'aide de l'équation 4 ci-dessous,

[Équation 4]

$$q_{22} = q_{22\_min} + \left( \frac{var_v}{(range_v \times accuracy_v)^2} \right) \times (q_{22\_max} - q_{22\_min})$$

où $q_{22}$ est la seconde composante de variance, $q_{22\_min}$ est une valeur minimale prédéfinie de la seconde composante de variance, $q_{22\_max}$ est une valeur maximale prédéfinie de la seconde composante de variance, $var_v$ est la variance de tension, $range_v$ est une tension maximale mesurable de la spécification de mesure de tension, et $accuracy_v$ est une erreur de mesure de tension de la spécification de mesure de tension.

8. Appareil d'estimation de l'état d'une batterie selon la revendication 1,
dans lequel l'unité de calcul de bruit de système est configurée pour calculer le bruit de système en calculant un produit scalaire de la matrice de bruit de décalage, de la matrice de bruit de variance et d'une matrice de transposition de la matrice de bruit de décalage.

9. Appareil d'estimation de l'état d'une batterie selon la revendication 8,

dans lequel l'unité de calcul de bruit de système est configurée pour calculer le bruit de système à l'aide de l'équation 5 ci-dessous,

$$\text{[Équation 5]}$$

$$\Sigma_w = WQW^T$$

où $\Sigma_w$ est le bruit de système, W est la matrice de bruit de décalage, $W_T$ est la matrice transposée de la matrice de bruit de décalage, et Q est la matrice de bruit de variance.

10. Appareil d'estimation de l'état d'une batterie selon la revendication 1,
dans lequel le filtre récursif est configuré sous la forme d'un filtre de Kalman étendu adaptatif double comportant un premier filtre de Kalman étendu qui prédit et corrige le SOC et la covariance du SOC de la batterie et un second filtre de Kalman étendu qui prédit et corrige le SOH et la covariance du SOH de la batterie.

11. Appareil d'estimation de l'état d'une batterie selon la revendication 10,
dans lequel le premier filtre de Kalman étendu est configuré pour prédire le SOC d'un cycle actuel sur la base du SOC de la batterie estimé dans un cycle précédent et de la matrice de bruit de décalage, prédire la covariance du SOC du cycle actuel sur la base de la covariance du SOC de la batterie estimée dans le cycle précédent et du bruit de système, et estimer le SOC et la covariance du SOC de la batterie dans le cycle actuel sur la base du SOC prédit, de la covariance du SOC prédite et du SOH prédit par le second filtre de Kalman étendu.

12. Appareil d'estimation de l'état d'une batterie selon la revendication 10,
dans lequel le second filtre de Kalman étendu est configuré pour prédire le SOH d'un cycle actuel sur la base du SOH de la batterie estimé dans un cycle précédent, prédire la covariance du SOH du cycle actuel sur la base de la covariance du SOH de la batterie estimée dans le cycle précédent et de la matrice de bruit de variance, et estimer le SOH et la covariance du SOH de la batterie dans le cycle actuel sur la base du SOH prédit, de la covariance du SOH prédite et du SOC prédit par le premier filtre de Kalman étendu.

13. Bloc-batterie (1),
comprenant l'appareil d'estimation de l'état d'une batterie selon l'une quelconque des revendications 1 à 12.

14. Système de stockage d'énergie comprenant l'appareil d'estimation de l'état d'une batterie selon l'une quelconque des revendications 1 à 12.

15. Procédé d'estimation de l'état d'une batterie, comprenant :

une étape d'obtention de tension et de courant pour obtenir une valeur de tension et une valeur de courant d'une batterie ;
une étape de calcul de décalage et de variance pour calculer un décalage de tension et une variance de tension sur la base d'une valeur de tension de la batterie obtenue pendant une période prédéterminée et calculer un décalage de courant et une variance de courant sur la base d'une valeur de courant de la batterie obtenue pendant la période prédéterminée ;
une étape de calcul de matrice de bruit pour calculer une matrice de bruit de décalage et une matrice de bruit de variance sur la base du décalage de tension, de la variance de tension, d'une spécification de mesure de tension prédéfinie, du décalage de courant, de la variance de courant et d'une spécification de mesure de courant prédéfinie ;
une étape de calcul de bruit de système pour calculer un bruit de système à partir de la matrice de bruit de décalage et de la matrice de bruit de variance ; et
une étape d'estimation d'informations d'état de batterie pour estimer des informations d'état de la batterie en appliquant le bruit de système à un filtre récursif prédéfini.

FIG. 1

FIG. 2

FIG. 3

FIG. 4

```
                    ┌─────────────┐
                    │    START    │
                    └─────────────┘
                           │
                           ▼
S100 ─┤  VOLTAGE AND CURRENT OBTAINING STEP  │
                           │
                           ▼
S200 ─┤  OFFSET AND VARIANCE CALCULATING STEP  │
                           │
                           ▼
S300 ─┤  NOISE MATRIX CALCULATING STEP  │
                           │
                           ▼
S400 ─┤  SYSTEM NOISE CALCULATING STEP  │
                           │
                           ▼
S500 ─┤  BATTERY STATE INFORMATION ESTIMATING STEP  │
                           │
                           ▼
                    ┌─────────────┐
                    │     END     │
                    └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220001089

- CN 110333456 A

**Non-patent literature cited in the description**

- **YONGLIANG ZHENG et al.** SOC Estimation of Lithium Battery Based on Dual Adaptive Extended Kalman Filter. *IMMAEE*, 2019